# EUROPEAN PATENT APPLICATION

(11) **EP 4 682 963 A1**
(43) Date of publication of application: **21.01.2026**
(21) Application number: 24770747.4
(22) Date of filing: 08.03.2024
(51) Int. Cl.: H01L 33/24, H01L 33/04

(54) **SEMICONDUCTOR LIGHT EMITTING ELEMENT AND METHOD FOR PRODUCING SEMICONDUCTOR LIGHT EMITTING ELEMENT**

(30) Priority: 15.03.2023 JP 2023041444
(71) Applicant: Koito Manufacturing Co., Ltd., Shinagawa-ku, Tokyo 141-0001 (JP)
(72) Inventor: SONE, Naoki, Shizuoka-shi, Shizuoka 424-8764 (JP)
(74) Representative: Stöckeler, Ferdinand
(86) International application number: PCT/JP2024/008944
(87) International publication number: WO 2024/190641

(57) **Abstract**

Provided are a semiconductor light emitting element capable of efficiently removing hydrogen from a p-type semiconductor layer, and a method for producing the semiconductor light emitting element. The semiconductor light emitting element includes: a growth substrate (11); a plurality of columnar semiconductor layers including an n-type core layer (15) erected in a vertical direction with respect to a main surface of the growth substrate (11) and an active layer (16) disposed on an outer periphery of the n-type core layer (15); a plurality of p-type semiconductor layers (17) arranged on an outer periphery of the columnar semiconductor layers and connected to each other to be integrated; and a removal region in which a part of the plurality of p-type semiconductor layers (17) integrated is removed.

## Description

### TECHNICAL FIELD

The present invention relates to a semiconductor light emitting element and a method for producing the semiconductor light emitting element.

### BACKGROUND ART

The semiconductor light emitting element emits light by recombination of holes and electrons in an active layer. Conventionally, a flat sheet-like well layer has been used as the active layer. On the other hand, in recent years, development of a semiconductor light emitting element having a three-dimensional nanostructure has been activated. Patent Literature 1 discloses an example of the semiconductor light emitting element having such a structure.

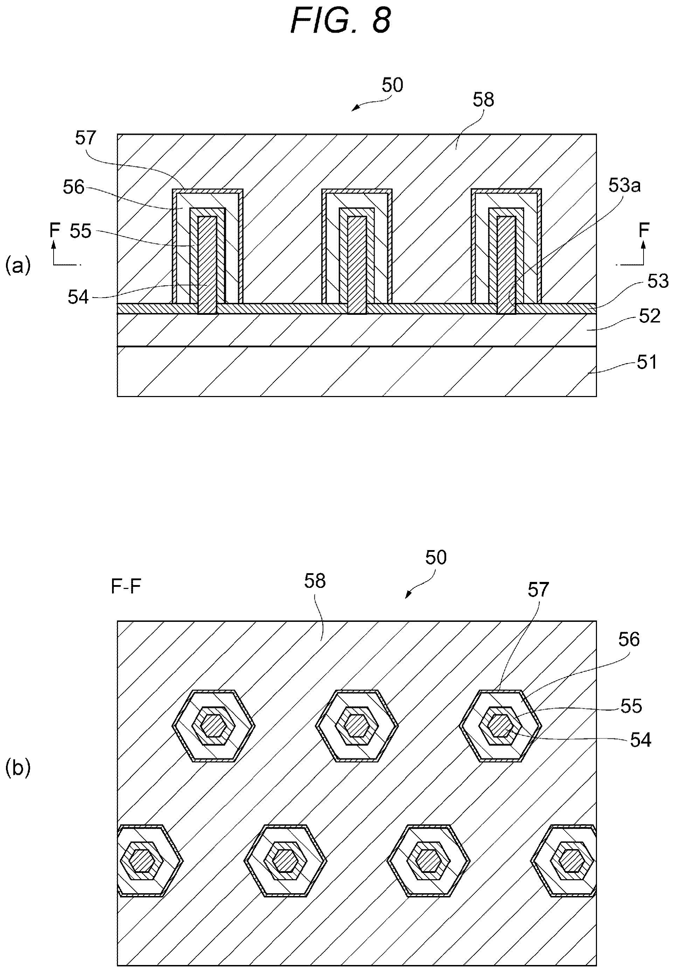

A main body of the semiconductor light emitting element according to Patent Literature 1 is formed of a thin wire structure called a nanowire. Figs. 8(a) and 8(b) are views illustrating a semiconductor light emitting element 50 according to a conventional technique in which the semiconductor light emitting element according to Patent Literature 1 is simplified, in which Fig. 8(a) illustrates a longitudinal sectional view, and Fig. 8(b) illustrates a transverse sectional view. As illustrated in Fig. 8(a), the semiconductor light emitting element 50 includes a growth substrate 51, an underlying layer 52, a mask 53, an n-type core layer 54 grown in a hexagonal prism shape, an active layer (a light emitting layer) 55 formed around the n-type core layer 54, a p-type semiconductor layer 56 formed around the active layer 55, a tunnel junction layer 57 formed around the p-type semiconductor layer 56, and an embedded semiconductor layer 58. A portion including the n-type core layer 54, the active layer 55, the p-type semiconductor layer 56, and the tunnel junction layer 57 is generally referred to as the nanowire. The embedded semiconductor layer 58 is embedded with the nanowire. According to such a structure, a current can be uniformly injected into the light emitting layer. In addition, a plurality of nanowires is connected by the embedded semiconductor layer 58, and strength is secured.

Here, the p-type semiconductor layer 56 of the semiconductor light emitting element 50 and a p+ layer of the tunnel junction layer 57 (hereinafter, both may be collectively referred to as a "p-type semiconductor layer") need to be activated by removing hydrogen. Mg (magnesium), which is a dopant contained in the p-type semiconductor layer, is deactivated by passivation with hydrogen. Therefore, it is necessary to remove hydrogen by heat treatment, to activate Mg. For this purpose, the p-type semiconductor layer is exposed in the middle of a process and subjected to an annealing treatment. However, since the p-type semiconductor layer is covered with the n-type embedded semiconductor layer 58 and an n+ layer of the tunnel junction layer 57, hydrogen cannot be effectively removed, and therefore sufficient activation cannot be performed. When the activation is insufficient, this layer has high resistance, and an element efficiency of the semiconductor light emitting element 50 decreases. In this regard, in the semiconductor light emitting element according to Patent Literature 1, a removal region for exposing the p-type semiconductor layer is provided on an upper portion of the semiconductor light emitting element, and hydrogen is removed from the removal region.

### CITATION LIST

### PATENT LITERATURE

Patent Literature 1: JP-A-2022-040676

### SUMMARY OF INVENTION

### PROBLEMS TO BE SOLVED BY INVENTION

As described above, in the semiconductor light emitting element and the method for producing the same according to Patent Literature 1, an upper portion of the p-type semiconductor layer is exposed and annealed. At this time, since the nanowires are independent from each other, it is necessary to expose upper portions of p-type semiconductor layers of all the nanowires. In this method, hydrogen is removed from the upper portion. However, since an exposed area of a nanowire structure is small, the annealing treatment tends to take a long time in order to sufficiently perform activation treatment up to a lower portion of the nanowire structure.

Therefore, the present invention has been made in view of the above-described conventional problems, and an object of the present invention is to provide a semiconductor light emitting element capable of efficiently removing hydrogen from the p-type semiconductor layer, and a method for producing the semiconductor light emitting element.

### SOLUTION TO PROBLEMS

In order to solve the above problems, a semiconductor light emitting element according to the present invention includes: a growth substrate; a plurality of columnar semiconductor layers including an n-type core layer erected in a vertical direction with respect to a main surface of the growth substrate and an active layer disposed on an outer periphery of the n-type core layer; a plurality of p-type semiconductor layers arranged on an outer periphery of the columnar semiconductor layers and connected to each other to be integrated; and a removal region in which a part of the plurality of p-type semiconductor layers integrated is removed.

Such a semiconductor light emitting element of the present invention includes the removal region in which a part of the plurality of p-type semiconductor layers arranged on the outer periphery of the columnar semiconductor layer and connected to each other to be integrated is removed, so that hydrogen can be efficiently removed from the p-type semiconductor layer.

In addition, in one aspect of the present invention, each of the plurality of p-type semiconductor layers forms a cone extending downward in the vertical direction, and the plurality of p-type semiconductor layers are connected to each other at a lower portion of the cone.

In addition, in one aspect of the present invention, the semiconductor light emitting element further includes: an underlying layer formed on the growth substrate and continuous with the n-type core layer; and an opening surrounded by a connecting portion where the p-type semiconductor layers are connected to each other, in which the p-type semiconductor layer is not disposed in the opening.

In addition, in one aspect of the present invention, the semiconductor light emitting element further includes an embedded semiconductor layer disposed on an outer periphery of the p-type semiconductor layer, in which a layer extending from an upper surface of the embedded semiconductor layer to the underlying layer is removed in the removal region, and an end surface of the p-type semiconductor layer is exposed from the removal region.

In addition, in one aspect of the present invention, the semiconductor light emitting element further includes a tunnel junction layer disposed between the p-type semiconductor layer and the embedded semiconductor layer, in which an end surface of the tunnel junction layer is further exposed from the removal region.

In order to solve the above problems, a method for producing a semiconductor light emitting element according to the present invention includes: a mask forming step of forming a mask having a plurality of openings on a growth substrate; a columnar semiconductor layer forming step of forming an n-type core layer in the openings using selective growth and forming an active layer on an outer periphery of the n-type core layer to form a columnar semiconductor layer; a p-type semiconductor layer forming step of forming a p-type semiconductor layer on an outer periphery of the columnar semiconductor layer; an embedded semiconductor layer forming step of forming an embedded semiconductor layer on the growth substrate so as to embed the p-type semiconductor layer; a removal region forming step of removing a part of the p-type semiconductor layer and a part of the embedded semiconductor layer to expose the p-type semiconductor layer; and an activating step of annealing an entire p-type semiconductor layer to activate the p-type semiconductor layer.

In addition, an aspect of the present invention, the method for producing the semiconductor light emitting element further includes a tunnel junction layer forming step of forming a tunnel junction layer on an outer periphery of the p-type semiconductor layer, in which the embedded semiconductor layer is formed to embed the tunnel junction layer, the tunnel junction layer is further exposed in the removal region forming step, and the tunnel junction layer is further activated in the activating step.

### EFFECTS OF INVENTION

The present invention can provide a semiconductor light emitting element capable of efficiently removing hydrogen from a p-type semiconductor layer, and a method for producing the semiconductor light emitting element.

### BRIEF DESCRIPTION OF DRAWINGS

Fig. 1(a) is a plan view and Fig. 1(b) is a longitudinal sectional view of a semiconductor light emitting element according to a first embodiment.
Fig. 2(a) is a plan view, Fig. 2(b) is a longitudinal sectional view, Fig. 2(c) is a transverse sectional view, and Fig. 2(d) is a longitudinal sectional view of the semiconductor light emitting element according to the first embodiment.
Figs. 3(a) to 3(e) are longitudinal sectional views in a method for producing the semiconductor light emitting element according to the first embodiment, in which Fig. 3(a) illustrates an underlying layer forming step, Fig. 3(b) illustrates a mask forming step, Fig. 3(c) illustrates an opening forming step, Fig. 3(d) illustrates a columnar semiconductor layer forming step, and Fig. 3(e) illustrates a p-type semiconductor layer/tunnel junction layer forming step.
Figs. 4(a) to 4(c) are longitudinal sectional views in the method for producing the semiconductor light emitting element according to the first embodiment, in which Fig. 4(a) illustrates an embedded semiconductor layer forming step, Fig. 4(b) illustrates a removal region forming/activating step, and Fig. 4(c) illustrates an electrode forming step.
Fig. 5 is a plan view illustrating a wafer according to the first embodiment.
Fig. 6(a) is a plan view and Fig. 6(b) is a perspective view illustrating an SEM image of a p-type semiconductor layer of the semiconductor light emitting element according to the first embodiment.
Fig. 7(a) is a plan view, Fig. 7(b) is a longitudinal sectional view, Fig. 7(c) is a transverse sectional view, and Fig. 7(d) is a longitudinal sectional view of the semiconductor light emitting element according to a second embodiment.
Fig. 8(a) is a longitudinal sectional view and Fig. 8(b) is a transverse sectional view of the semiconductor light emitting element according to a conventional technique.

### DESCRIPTION OF EMBODIMENTS

Hereinafter, embodiments of the present invention will be described in detail with reference to the drawings. The same or equivalent components, members, and processings illustrated in the drawings are denoted by the same reference numerals, and redundant description will be omitted as appropriate. In addition, materials and numerical values mentioned in the following description are merely examples, and are not limited thereto.

### (First embodiment)

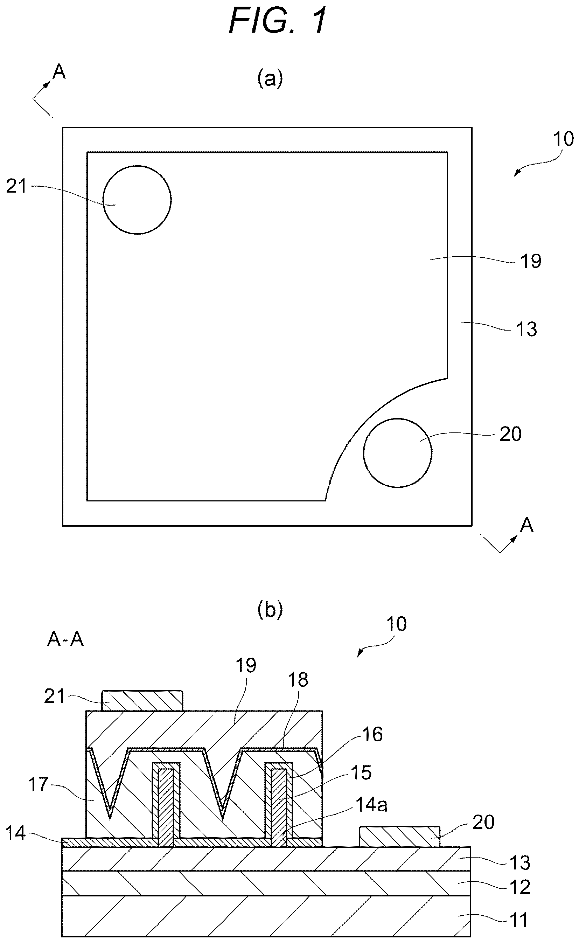

A semiconductor light emitting element and a method for producing the semiconductor light emitting element according to the present embodiment will be described with reference to Figs. 1 to 6. Fig. 1(a) is a plan view of a semiconductor light emitting element 10 according to the present embodiment, and Fig. 1(b) is a longitudinal sectional view taken along a cutting line A-A illustrated in Fig. 1(a). As illustrated in Fig. 1(a), the semiconductor light emitting element 10 includes an underlying layer 13, an embedded semiconductor layer 19, a cathode electrode 20, and an anode electrode 21. The cathode electrode 20 is formed on the underlying layer 13, and the anode electrode 21 is formed on the embedded semiconductor layer 19.

As illustrated in Fig. 1(b), the semiconductor light emitting element 10 includes a growth substrate 11, a buffer layer 12, the underlying layer 13, a mask 14, an n-type core layer 15, an active layer 16, a p-type semiconductor layer 17, a tunnel junction layer 18, the embedded semiconductor layer 19, the cathode electrode 20, and the anode electrode 21. An opening 14a is formed in the mask 14.

The growth substrate 11 is a substantially flat plate-like member made of a material capable of crystal-growing a semiconductor material. The growth substrate 11 is not particularly limited, but is a single crystal c-plane sapphire substrate in the present embodiment. The growth substrate 11 may be a single crystal substrate made of a material for growing a semiconductor single crystal layer via the buffer layer 12 described later, and the c-plane sapphire substrate is preferable when the semiconductor light emitting element 10 is made of a nitride-based semiconductor. However, the growth substrate 11 is not limited thereto, and other dissimilar substrates such as Si may be used.

The buffer layer 12 is a layer that is formed between the growth substrate 11 and the underlying layer 13 to be described later and alleviates lattice mismatch between the growth substrate and the underlying layer. As a material of the buffer layer 12, non-doped GaN is preferably used when the c-plane sapphire substrate is used as the growth substrate 11. However, the buffer layer 12 is not limited thereto, and AlN, AlGaN, or the like may be used. Note that the growth substrate 11 may be made of a single material without forming the buffer layer 12.

The underlying layer 13 is a single crystal semiconductor layer formed on the growth substrate 11 or the buffer layer 12, and preferably includes a plurality of layers in which non-doped GaN is formed in a thickness of several µm and an n-type semiconductor layer (not illustrated) such as an n-type contact layer is provided thereon. The n-type contact layer is a semiconductor layer doped with an n-type impurity, and examples thereof include Si-doped n-type Al_{0.05}Ga_{0.95}N.

The mask 14 is a layer made of a dielectric material formed on a surface of the underlying layer 13. As a material constituting the mask 14, a material in which crystal growth of a semiconductor is difficult from the mask 14 is selected, and for example, SiO₂, SiNx, Al₂O₃, or the like is suitable. A plurality of the openings 14a is formed in the mask 14, and the semiconductor layer can be grown from the underlying layer 13 partially exposed from the openings 14a.

The n-type core layer 15 is a hexagonal prism-shaped semiconductor layer selectively grown on the underlying layer 13 exposed from the opening 14a of the mask 14, and is made of, for example, GaN doped with an n-type impurity.

The active layer (light emitting layer) 16 is a semiconductor layer grown on an outer periphery of the n-type core layer 15, and is, for example, a multiple quantum well active layer in which a GaInN quantum well layer having a thickness of 5 nm and a GaN barrier layer having a thickness of 10 nm are stacked for 5 cycles. Although the multiple quantum well active layer is mentioned here, it may be a single quantum well structure or a bulk active layer. Since the active layer 16 is formed on a side surface and an upper surface of the n-type core layer 15, an area of the active layer 16 can be secured. Note that in the present embodiment, a portion including the n-type core layer 15 and the active layer 16 is referred to as a "columnar semiconductor layer".

The p-type semiconductor layer 17 is a semiconductor layer grown on an outer periphery of the active layer 16, and is made of, for example, GaN doped with a p-type impurity. The p-type semiconductor layer 17 covers a side surface and an upper surface of the active layer 16, and is formed to have a trapezoidal shape (hereinafter, this shape is referred to as a "cone") in a longitudinal sectional view as illustrated in Fig. 1(b). In other words, the p-type semiconductor layer 17 is formed to cover each of the columnar semiconductor layers. Note that in the present embodiment, a form in which a top of the cone is flat will be described as an example, but the top may be pointed as described later. Then, p-type semiconductor layers 17 of the columnar semiconductor layers are partially connected to each other at lower portions thereof. That is, the p-type semiconductor layers 17 divided into a plurality of parts are formed with their bottoms widened so as to be connected and integrated at the lower portions thereof. The n-type core layer 15, the active layer 16, and the p-type semiconductor layer 17 constitute a double heterostructure, and carriers can be well confined in the active layer 16 to improve probability of light emission recombination.

Here, as illustrated in Fig. 8(a), p-type semiconductor layers 56 are respectively separated for nanowires in a semiconductor light emitting element 50 according to the conventional technique, but the p-type semiconductor layer 17 of the semiconductor light emitting element 10 according to the present embodiment is integrally formed by connecting the p-type semiconductor layers 17 to each other as described above. Thus, in the semiconductor light emitting element 10 according to the present embodiment, hydrogen in the p-type semiconductor layer 17 of a certain columnar semiconductor layer can move to the p-type semiconductor layers 17 of adjacent columnar semiconductor layers. Therefore, if a partial region of the integrated p-type semiconductor layer 17 is exposed and annealed, an entire p-type semiconductor layer 17 can be activated. The same applies to a p+ layer of the tunnel junction layer 18 to be described later. Details of a structure of the p-type semiconductor layer 17 will be described later.

The tunnel junction layer 18 is a semiconductor layer grown on an outer periphery of the p-type semiconductor layer 17, and has a two-layer structure in which, for example, a p+ layer highly doped with a p-type impurity inside and an n+ layer highly doped with a n-type impurity outside are sequentially grown. The p+ layer is a semiconductor layer highly doped with a p-type impurity, and for example, GaN having a thickness of 5 nm and a Mg concentration of 2×10²⁰ cm⁻³ can be used. As the n+ layer, for example, GaN having a thickness of 10 nm and a Si concentration of 2×10²⁰ cm⁻³ can be used. A tunnel junction is formed by the p+ layer and the n+ layer. That is, the tunnel junction layer 18 according to the present embodiment includes two layers of the p+ layer and the n+ layer. As described above, the p+ layer of the tunnel junction layer 18 is also preferably activated.

The embedded semiconductor layer 19 is a semiconductor layer formed to cover an upper surface and a side surface of the tunnel junction layer 18. A material of the embedded semiconductor layer 19 is, for example, n-type GaN.

A cathode electrode 20 illustrated in Fig. 1(b) is a negative electrode for supplying a current to the semiconductor light emitting element 10. As illustrated in Fig. 1, the cathode electrode 20 is formed on the exposed n-type underlying layer 13. More specifically, it is constituted by a laminated structure of a metal material in ohmic contact with the exposed underlying layer 13 and a pad electrode. The anode electrode 21 is a positive electrode for supplying the current to the semiconductor light emitting element 10. The anode electrode 21 is formed on a part of the embedded semiconductor layer 19, and is constituted by a laminated structure of a metal material in ohmic contact with an outermost surface of the embedded semiconductor layer 19 and a pad electrode. Note that the anode electrode 21 may be a transparent electrode extended to cover substantially the entire embedded semiconductor layer 19. If necessary, an insulating protective film (a passivation film) covering a predetermined surface of the semiconductor light emitting element 10 may be provided. The insulating protective film protects the semiconductor light emitting element 10 from an external environment such as moisture.

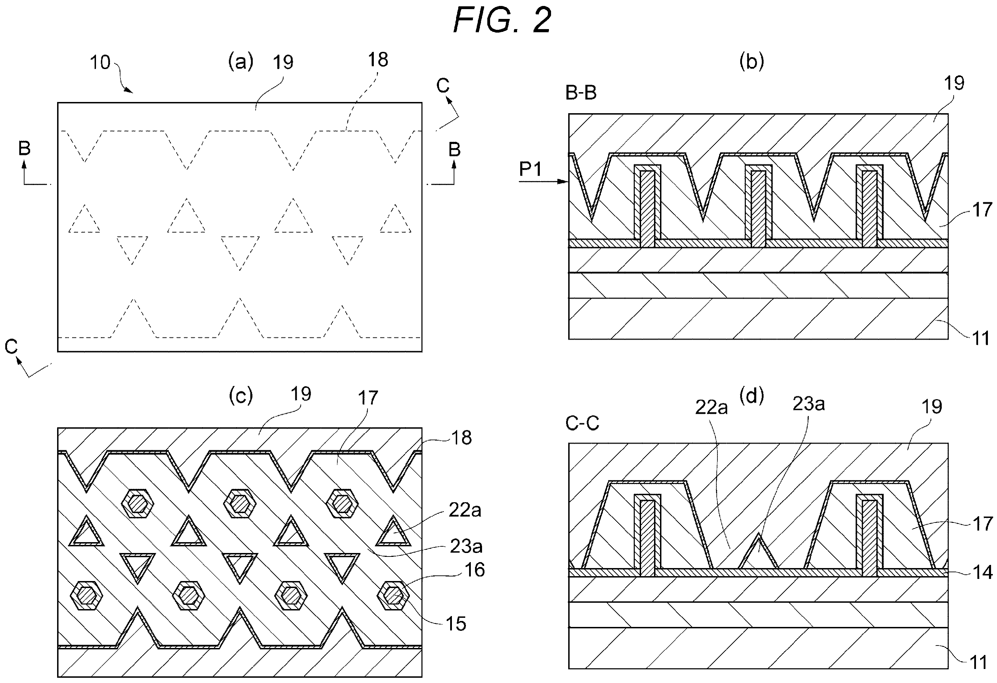

Structural features of the p-type semiconductor layer 17 of the semiconductor light emitting element 10 according to the present embodiment will be described in more detail with reference to Fig. 2. Fig. 2(a) is a plan view of the semiconductor light emitting element 10, Fig. 2(b) is a longitudinal sectional view taken along a cutting line B-B illustrated in Fig. 2(a), Fig. 2(c) is a transverse sectional view taken along a portion corresponding to a position P1 illustrated in Fig. 2(b), and Fig. 2(d) is a longitudinal sectional view taken along a cutting line C-C illustrated in Fig. 2(a).

As illustrated in Fig. 2(a), a surface of the semiconductor light emitting element 10 is covered with the embedded semiconductor layer 19. Fig. 2(a) also illustrates an outer shape of the tunnel junction layer 18. An outer shape of the p-type semiconductor layer 17 is substantially similar to the outer shape of the tunnel junction layer 18. As illustrated in Fig. 2(b), when the semiconductor light emitting element 10 is cut in an arrangement direction of the columnar semiconductor layers (the n-type core layer 15 and the active layer 16), the p-type semiconductor layer 17 is formed continuously and integrally.

Fig. 2(c) is a transverse sectional view of the columnar semiconductor layer cut midway in a height direction thereof. As illustrated in Fig. 2(c), the n-type core layer 15 is surrounded by the active layer 16, and the periphery of the active layer 16 is covered with the p-type semiconductor layer 17. The periphery of the p-type semiconductor layer 17 is surrounded by the tunnel junction layer 18. The external shape of the p-type semiconductor layer 17 is substantially hexagonal reflecting a shape of the n-type core layer 15 having a hexagonal prism shape. Here, in the present embodiment, an arrangement form of the columnar semiconductor layers in plan view is a triangular lattice pattern. Therefore, as illustrated in Fig. 2(c), positions of the columnar semiconductor layers in a certain row are arranged to be shifted by a half from positions of adjacent columnar semiconductors.

Since the p-type semiconductor layer 17 grows around the columnar semiconductor layer, the adjacent p-type semiconductor layers 17 are connected to each other. In a triangular lattice arrangement, vertexes of the p-type semiconductor layers 17 of the adjacent columnar semiconductor layers are connected to each other. At that time, as illustrated in Fig. 2(c), openings 22a and connecting portions 23a are formed in the p-type semiconductor layer 17. In the opening 22a, the embedded semiconductor layer 19 is formed from its upper surface to the mask 14. Since the current injected from the anode electrode 21 directly reaches the mask 14 in the opening 22a, current injection into the active layer 16 is more efficient around the opening 22a. The connecting portion 23a refers to a portion where the p-type semiconductor layers 17 adjacent to each other are in contact with each other. Fig. 2(d) is a longitudinal sectional view of the opening 22a and the connecting portion 23a.

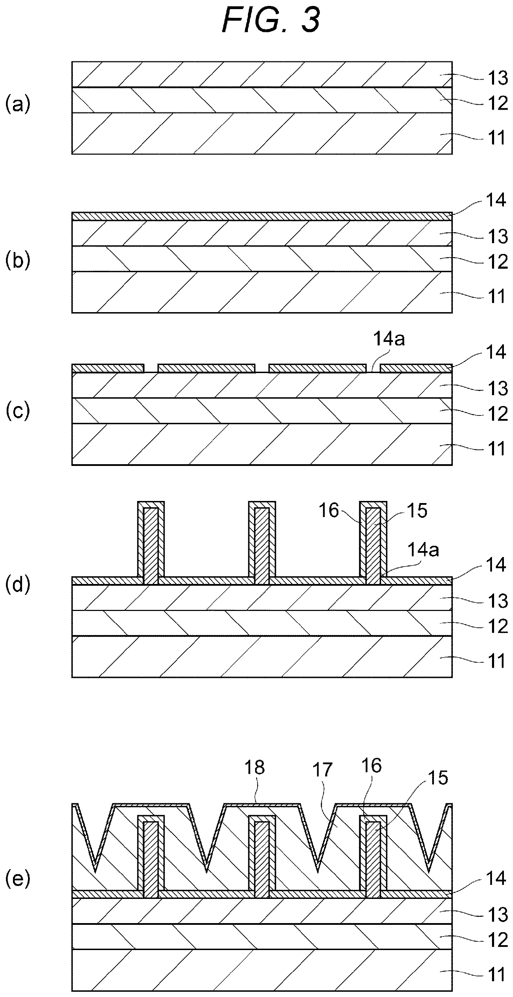

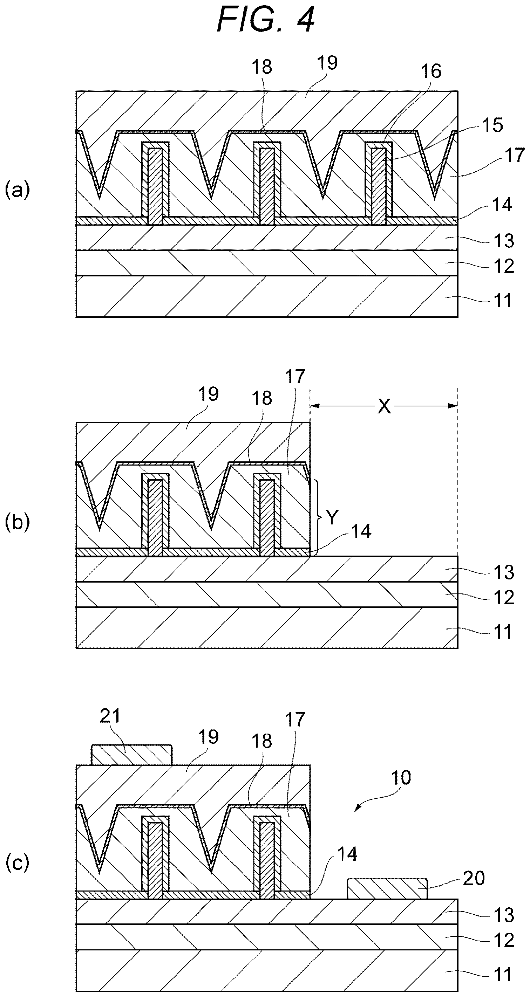

A method for producing the semiconductor light emitting element 10 according to the present embodiment will be described with reference to Figs. 3 to 5. Figs. 3(a), 3(b), 3(c), 3(d), and 3(e) are longitudinal sectional views respectively illustrating an underlying layer forming step, a mask forming step, an opening forming step, a columnar semiconductor layer forming step, and a p-type semiconductor layer/tunnel junction layer forming step. Figs. 4(a), 4(b), and 4(c) are longitudinal sectional views respectively illustrating an embedded semiconductor layer forming step, a removal region forming/activating step, and an electrode forming step. Note that the semiconductor light emitting element 10 is produced in a state of a semiconductor wafer in which a plurality of element formation regions is arranged, but in the following description, description will be given focusing on one element formation region among the element formation regions.

First, in the underlying layer forming step illustrated in Fig. 3(a), the buffer layer 12 made of GaN and the underlying layer 13 made of GaN and AlGaN are grown on the growth substrate 11 made of a sapphire single crystal as an example by metal organic chemical vapor deposition (MOCVD). Note that as described above, a substrate made of a single material, for example, n-type GaN may be used as the growth substrate 11.

Next, in the mask forming step illustrated in Fig. 3(b), the mask 14 made of SiO₂ is deposited on the underlying layer 13 by a sputtering method with a film thickness of about 30 nm.

Next, in the opening forming step illustrated in Fig. 3(c), the opening 14a having a diameter of about 150 nm is formed using a fine pattern-forming method such as nanoimprinting lithography.

Next, in the columnar semiconductor layer forming step illustrated in Fig. 3 (d), first, the n-type core layer 15 made of GaN is grown on the underlying layer 13 exposed from the opening 14a by selective growth by an MOCVD method. As growth conditions of the n-type core layer 15, for example, TMG and ammonia are used as source gases, a growth temperature is 1050°C, a V/III ratio is 10, and a pressure is 900hPa using hydrogen as a carrier gas.

Next, the active layer 16 in which the GaInN quantum well layer having a thickness of 5 nm and the GaN barrier layer having a thickness of 10 nm are stacked for 5 cycles is formed on the side surface and the upper surface of the n-type core layer 15 by using the MOCVD method. As growth conditions of the active layer 16, for example, the growth temperature is 800°C, the V/III ratio is 3000, the pressure is 1000hPa using nitrogen as the carrier gas, and TMG, trimethyl indium (TMI), and ammonia are used as the source gases.

Next, in the p-type semiconductor layer forming step of the p-type semiconductor layer/tunnel junction layer forming step illustrated in Fig. 3(e), the p-type semiconductor layer 17 made of GaN doped with a p-type impurity is formed. As described above, the p-type semiconductor layer 17 of the semiconductor light emitting element 10 according to the present embodiment is formed to form a cone extending downward. A cross-sectional shape of the cone is preferably hexagonal.

The cone is formed by gradually increasing a thickness of the p-type semiconductor layer from a top to a bottom thereof. More specifically, the cone is formed as follows. That is, the cone is formed at a relatively low temperature and a low V/III ratio compared to growth conditions of the hexagonal prism-shaped p-type semiconductor layer 56 illustrated in Fig. 8(a). The growth conditions of the p-type semiconductor layer 56 are, for example, a growth temperature of about 950°C and a V/III ratio of about 1000. In this case, the growth conditions of the p-type semiconductor layer 17 are, for example, a growth temperature of about 850°C to 900°C and a V/III ratio of about 500 to 800. The pressure at that time is about 300hPa using hydrogen as the carrier gas, and TMG, Cp2Mg (bisCycropentadienyl Magnesium), and ammonia are used as the source gases. The top of the cone may be a flat c-plane or may be pointed without a plane. By making the p-type semiconductor layer 17 conical, the tunnel junction layer 18 and the embedded semiconductor layer 19 to be described later can be formed while suppressing generation of voids.

Next, in the tunnel junction layer forming step, the tunnel junction layer 18 is formed to cover a side surface and an upper surface of the p-type semiconductor layer 17. As growth conditions of the tunnel junction layer 18, for example, the growth temperature is 800°C, the V/III ratio is 3000, and the pressure is 500hPa using nitrogen as the carrier gas. In the tunnel junction layer forming step, the tunnel junction layer 18 including a p+ layer made of GaN having a thickness of 5 nm and a Mg concentration of 2×10²⁰ cm⁻³ and an n+ layer made of GaN having a thickness of 10 nm and a Si concentration of 2×10²⁰ cm⁻³ is sequentially grown.

Next, in the embedded semiconductor layer forming step illustrated in Fig. 4(a), the embedded semiconductor layer 19 made of n-type GaN is grown, and an outer periphery and an upper surface of the tunnel junction layer 18 are filled with the embedded semiconductor layer 19. In growth of the embedded semiconductor layer 19, TMG, silane, and ammonia are used as the source gases. Note that for convenience of illustration, Fig. 4(a) illustrates the p-type semiconductor layer 17 as being exposed from both end surfaces, but the periphery of the p-type semiconductor layer 17 is actually covered with the embedded semiconductor layer 19.

Next, in the removal region forming step of the removal region forming/activating step illustrated in Fig. 4(b), the upper surface of the embedded semiconductor layer 19 to an upper surface of the underlying layer 13 are selectively etched to form a removal region X so as to expose the underlying layer 13. At this time, an exposed portion Y is formed on end surfaces after removal. In the exposed portion Y, the mask 14, the p-type semiconductor layer 17, and the tunnel junction layer 18 are exposed. As etching in this step, for example, dry etching is used. Fig. 4(b) illustrates a form in which a part of laminated semiconductor layers is removed, but the present embodiment is not limited thereto, and the removal region may be formed over an entire circumference of the semiconductor layer, and a mesa-shaped semiconductor layer may be formed on the underlying layer 13. In this way, an annealing treatment described later can be more efficiently performed.

After the removal region X is formed, the activating step is performed, and hydrogen is removed from the p-type semiconductor layer 17 and the p+ layer of the tunnel junction layer 18 exposed from the exposed portion to perform an activation treatment. Here, a method of the activation treatment is not limited, and examples thereof include heat treatment (annealing) at 600°C in an air atmosphere. In the present embodiment, the heat treatment in the air atmosphere is exemplified, but any heat treatment may be used as long as the heat treatment can activate the p-type semiconductor layer and is performed in an atmosphere in which there is no atomic hydrogen.

Next, in the electrode forming step illustrated in Fig. 4(c), the cathode electrode 20 is formed on the surface of the underlying layer 13 exposed in the removal region X, and the anode electrode 21 is formed on the embedded semiconductor layer 19. In the present embodiment, a form in which the anode electrode 21 is formed on a part of the embedded semiconductor layer 19 will be described as an example, but as described above, an electrode using ITO or the like may be formed on substantially an entire upper surface of the embedded semiconductor layer 19.

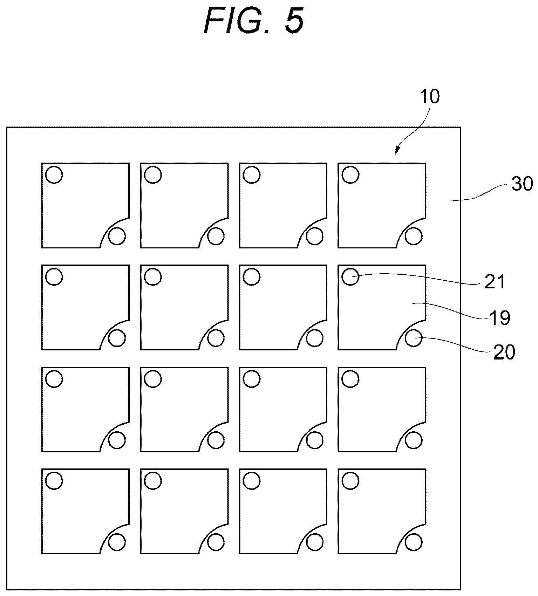

Fig. 5 illustrates a semiconductor wafer 30 that has been produced. An outer shape of the semiconductor wafer is generally circular, but Fig. 5 illustrates a case where the outer shape is rectangular. As illustrated in Fig. 5, a plurality of the semiconductor light emitting elements 10 are formed on the semiconductor wafer 30. When the semiconductor light emitting element 10 is viewed in a plan view, the embedded semiconductor layer 19, the cathode electrode 20, and the anode electrode 21 can be seen. The semiconductor wafer 30 is cut along a scribe line (not illustrated) provided between the semiconductor light emitting elements 10 and divided into individual semiconductor light emitting elements 10 (element division). A chip size after the division is, for example, 0.5 mm×0.5 mm. The semiconductor light emitting element 10 is mounted on a package or the like as necessary and put into practical use.

In the semiconductor light emitting element 10 of the present embodiment, when a voltage is applied between the cathode electrode 20 and the anode electrode 21, the current flows in the order of the anode electrode 21, the embedded semiconductor layer 19, the tunnel junction layer 18, the p-type semiconductor layer 17, the active layer 16, the n-type core layer 15, the underlying layer 13, the cathode electrode 20, and light is emitted by the light emission recombination in the active layer 16. The light generated in the active layer 16 is extracted to an outside of the semiconductor light emitting element 10.

In the semiconductor light emitting element 10 of the present embodiment, the active layer 16 is formed on the outer periphery of the n-type core layer 15, the p-type semiconductor layer 17 and the tunnel junction layer 18 are further formed on the outer periphery thereof, and further embedded with the embedded semiconductor layer 19. Therefore, the current injected from the anode electrode 21 is injected into the active layer 16 from a sidewall of the p-type semiconductor layer 17 as a tunnel current from the embedded semiconductor layer 19 through the tunnel junction layer 18. The current injection by the tunnel current through the tunnel junction layer 18 has a small resistance, and the current injection can be performed satisfactorily. In addition, since the embedded semiconductor layer 19 which is an n-type semiconductor layer is more likely to diffuse the current than the p-type semiconductor layer, the current can be injected from an entire tunnel junction layer 18. Thus, the current injected from the anode electrode 21 is injected into the active layer 16 not only from the upper surface but also from an entire side surface of the active layer 16. As a result, the current is favorably injected into the active layer 16, a high current density is realized, and external quantum efficiency can be improved.

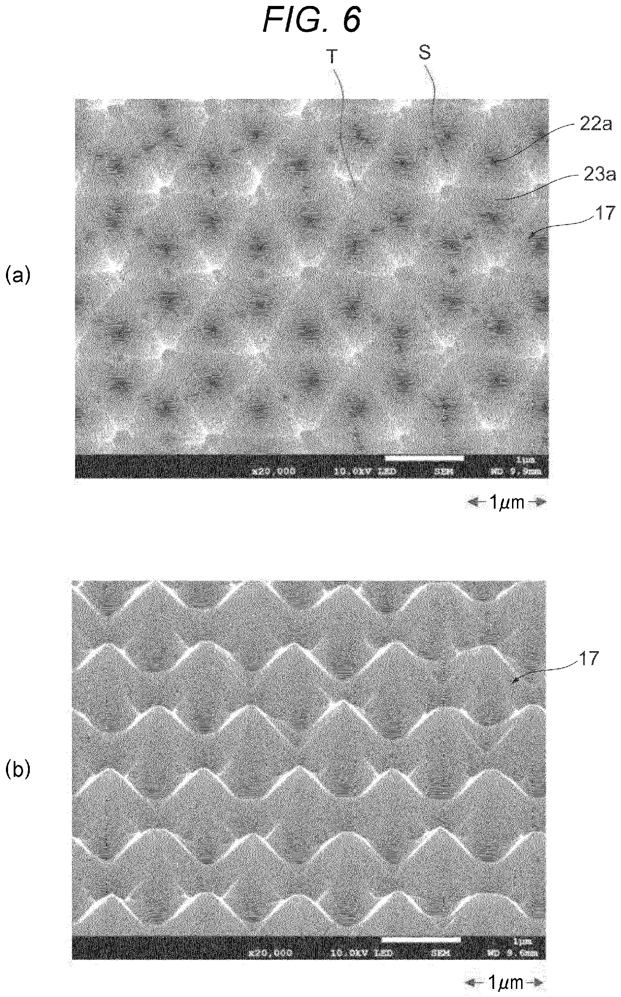

An example of the semiconductor light emitting element 10 according to the present embodiment will be described with reference to Fig. 6. Fig. 6 is a scanning electron microscope (SEM) image of the semiconductor light emitting element 10 actually produced halfway, and Fig. 6(a) is a plan view and Fig. 6(b) is a perspective view of a conical p-type semiconductor layer 17. However, the tunnel junction layer 18 and the embedded semiconductor layer 19 are not formed. As illustrated in Fig. 6(a), the plurality of p-type semiconductor layers 17 are connected by the connecting portions 23a, and the opening 22a is formed by being surrounded by three connecting portions 23a. As described above, the underlying layer 13 is exposed from the opening 22a.

A semipolar plane (101-1) appears on a slope S of the conical p-type semiconductor layer 17 illustrated in Fig. 6(a). When a growth time of the p-type semiconductor layer 17 is lengthened in the above producing process, a diameter and height of the cone increase while maintaining appearance of the semipolar plane. In addition, at a top T of the cone, the c-plane first appears, but as the growth time is increased, the c-plane is reduced, and the apex T is finally pointed. That is, the c-plane disappears and only the semipolar plane remains.

As described above in detail, according to the semiconductor light emitting element and the method for producing the semiconductor light emitting element according to the present embodiment, it is possible to provide a semiconductor light emitting element capable of efficiently removing hydrogen from the p-type semiconductor layer, and a method for producing the semiconductor light emitting element.

### (Second embodiment)

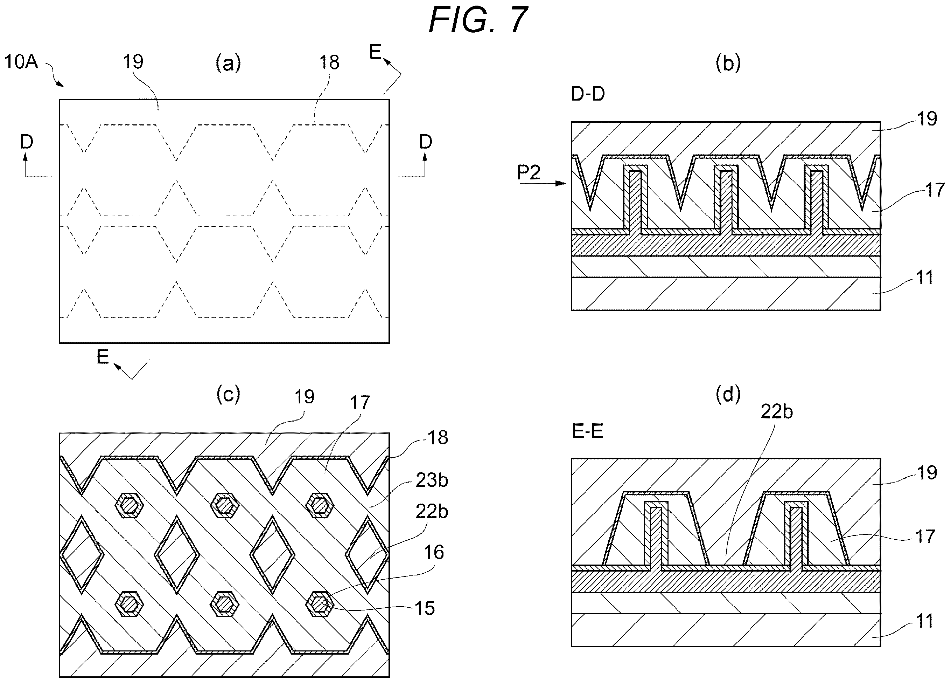

A semiconductor light emitting element 10A according to the present embodiment will be described with reference to Fig. 7. Fig. 7(a) is a plan view of the semiconductor light emitting element 10A, Fig. 7(b) is a longitudinal sectional view taken along a cutting line D-D illustrated in Fig. 7(a), Fig. 7(c) is a transverse sectional view taken along a portion corresponding to a position P2 illustrated in Fig. 7(b), and Fig. 7(d) is a longitudinal sectional view taken along a cutting line E-E shown in Fig. 7(a). As illustrated in Fig. 7(a), the surface of the semiconductor light emitting element 10A is covered with the embedded semiconductor layer 19. Fig. 7(a) also illustrates the outer shape of the tunnel junction layer 18. The outer shape of the p-type semiconductor layer 17 is substantially similar to the outer shape of the tunnel junction layer 18.

The semiconductor light emitting element 10A has a form in which the arrangement form of the columnar semiconductor layers is changed in the semiconductor light emitting element 10. That is, in the semiconductor light emitting element 10, the columnar semiconductor layers are arranged in a triangular lattice pattern (see Fig. 2), but in the semiconductor light emitting element 10A, the columnar semiconductor layers are arranged in a rectangular lattice pattern.

As illustrated in Fig. 7(b), when the semiconductor light emitting element 10A is cut in the arrangement direction of the columnar semiconductor layers, the p-type semiconductor layer 17 is formed continuously and integrally.

Fig. 7(c) is a transverse sectional view of the columnar semiconductor layer (the n-type core layer 15 and the active layer 16) cut midway in the height direction thereof. In the transverse sectional view, the n-type core layer 15 is surrounded by the active layer 16, and the periphery of the active layer 16 is covered with the p-type semiconductor layer 17. The periphery of the p-type semiconductor layer 17 is surrounded by the tunnel junction layer 18. Here, as described above, in the semiconductor light emitting element 10A, the arrangement form of the columnar semiconductor layers in plan view is a rectangular lattice pattern. Therefore, as illustrated in Fig. 7(c), the p-type semiconductor layers 17 in adjacent columns of the columnar semiconductor layers are arranged at the same position, and are not shifted unlike the semiconductor light emitting element 10.

Since the p-type semiconductor layer 17 grows around the columnar semiconductor layer, the adjacent p-type semiconductor layers 17 are connected. In a rectangular lattice arrangement, sides and vertexes of the adjacent p-type semiconductor layers 17 are connected to each other. Therefore, as illustrated in Fig. 7(c), openings 22b and connecting portions 23b are formed in the p-type semiconductor layer 17. In the opening 22b, the embedded semiconductor layer 19 is formed from the upper surface to the mask 14. Since the current injected from the anode electrode 21 directly reaches the mask 14 in the opening 22b, the current injection into the active layer 16 is more efficient around the opening 22b. The connection portion 23b refers to a region where the adjacent p-type semiconductor layers 17 are in contact with each other. Fig. 7(d) is a longitudinal sectional view of the opening 22b and the connecting portion 23b.

As described above in detail, according to the semiconductor light emitting element and the method for producing the semiconductor light emitting element according to the present embodiment, it is also possible to provide the semiconductor light emitting element capable of efficiently removing hydrogen from the p-type semiconductor layer, and the method for producing the semiconductor light emitting element.

Note that the present invention is not limited to the above-described embodiments, and various modifications can be made within the scope indicated in the claims, and embodiments obtained by appropriately combining technical means disclosed in different embodiments are also included in the technical scope of the present invention.

The present international application claims priority based on Japanese Patent Application No. 2023-041444 filed on March 15, 2023, and the entire contents of Japanese Patent Application No. 2023-041444 are incorporated herein by reference.

The above description of specific embodiments of the present invention has been presented for the purpose of illustration. They are not intended to be exhaustive or to limit the present invention as it is in the form described. It is obvious to those skilled in the art that many modifications and variations can be made in light of the above description.

### LIST OF REFERENCE SIGNS

- 10, 10A: Semiconductor light emitting element
- 11: Growth substrate
- 12: Buffer layer
- 13: Underlying layer
- 14: Mask
- 14a: Opening
- 15: n-type core layer
- 16: Active layer
- 17: p-type semiconductor layer
- 18: Tunnel junction layer
- 19: Embedded semiconductor layer
- 20: Cathode electrode
- 21: Anode electrode
- 22a, 22b: Opening
- 23a, 23b: Connecting portion
- 30: Semiconductor wafer
- 50: Semiconductor light emitting element
- 51: Growth substrate
- 52: Underlying layer
- 53: Mask
- 54: n-type core layer
- 55: Active layer
- 56: p-type semiconductor layer
- 57: Tunnel junction layer
- 58: Embedded semiconductor layer
- P1, P2: Position
- S: Slope
- T: Top
- X: Removal region
- Y: Exposed portion

## Claims

1. A semiconductor light emitting element comprising:
a growth substrate;
a plurality of columnar semiconductor layers including an n-type core layer erected in a vertical direction with respect to a main surface of the growth substrate and an active layer disposed on an outer periphery of the n-type core layer;
a plurality of p-type semiconductor layers arranged on an outer periphery of the columnar semiconductor layers and connected to each other to be integrated; and
a removal region in which a part of the plurality of p-type semiconductor layers integrated is removed.

2. The semiconductor light emitting element according to claim 1, wherein
each of the plurality of p-type semiconductor layers forms a cone extending downward in the vertical direction, and the plurality of p-type semiconductor layers are connected to each other at a lower portion of the cone.

3. The semiconductor light emitting element according to claim 1, further comprising:
an underlying layer formed on the growth substrate and continuous with the n-type core layer; and
an opening surrounded by a connecting portion where the p-type semiconductor layers are connected to each other, wherein
the p-type semiconductor layer is not disposed in the opening.

4. The semiconductor light emitting element according to claim 3, further comprising:
an embedded semiconductor layer disposed on an outer periphery of the p-type semiconductor layer, wherein
a layer extending from an upper surface of the embedded semiconductor layer to the underlying layer is removed in the removal region, and
an end surface of the p-type semiconductor layer is exposed from the removal region.

5. The semiconductor light emitting element according to claim 4, further comprising:
a tunnel junction layer disposed between the p-type semiconductor layer and the embedded semiconductor layer, wherein
an end surface of the tunnel junction layer is further exposed from the removal region.

6. A method for producing a semiconductor light emitting element, the method comprising:
a mask forming step of forming a mask having a plurality of openings on a growth substrate;
a columnar semiconductor layer forming step of forming an n-type core layer in the openings using selective growth and forming an active layer on an outer periphery of the n-type core layer to form a columnar semiconductor layer;
a p-type semiconductor layer forming step of forming a p-type semiconductor layer on an outer periphery of the columnar semiconductor layer;
an embedded semiconductor layer forming step of forming an embedded semiconductor layer on the growth substrate so as to embed the p-type semiconductor layer;
a removal region forming step of removing a part of the p-type semiconductor layer and a part of the embedded semiconductor layer to expose the p-type semiconductor layer; and
an activating step of annealing an entire p-type semiconductor layer to activate the p-type semiconductor layer.

7. The method for producing the semiconductor light emitting element according to claim 6, further comprising
a tunnel junction layer forming step of forming a tunnel junction layer on an outer periphery of the p-type semiconductor layer, wherein
the embedded semiconductor layer is formed to embed the tunnel junction layer,
the tunnel junction layer is further exposed in the removal region forming step, and
the tunnel junction layer is further activated in the activating step.
